# EUROPEAN PATENT APPLICATION

(11) **EP 4 425 769 A1**
(43) Date of publication of application: **04.09.2024**
(21) Application number: 22886898.0
(22) Date of filing: 21.10.2022
(51) Int. Cl.: H02K 9/19, H02K 11/30

(54) **STATOR AND STRUCTURE**

(30) Priority: 27.10.2021 JP 2021175415
(71) Applicant: Sumitomo Bakelite Co.Ltd., Shinagawa-ku Tokyo 140-0002 (JP)
(72) Inventor: KOSAKA, Wataru, Tokyo 140-0002 (JP); YAMAMOTO, Shinya, Tokyo 140-0002 (JP); NISHIKAWA, Atsunori, Tokyo 140-0002 (JP); HARADA, Takahiro, Tokyo 140-0002 (JP)
(74) Representative: Müller-Boré & Partner Patentanwälte PartG mbB
(86) International application number: PCT/JP2022/039299
(87) International publication number: WO 2023/074571

(57) **Abstract**

A stator includes: a yoke portion; tooth portions extending from the yoke portion; a coil accommodated in slots formed between the tooth portions; and a cooling water channel (200) that cools the coil. The cooling water channel (200) includes coil inner water channels (301) disposed between one end and the other end in an axial direction to cool the coil, and a header water channel (310) that is connected to a plurality of the coil inner water channels (301), that is disposed outside the coil, and that distributes cooling water introduced into the coil inner water channels (301) or collects the cooling water discharged from the coil inner water channels (301). When a total cross-sectional area of the coil inner water channels (301) is S1, and a cross-sectional area of a surface of the header water channel (310), the surface being perpendicular to a movement direction of the cooling water, is S2, a ratio S2/S1 between the S1 and the S2 is equal to or more than 0.5.

## Description

### TECHNICAL FIELD

The present invention relates to a stator and a structure, and for example, relates to a stator provided with a cooling flow channel and a structure including such a stator.

### BACKGROUND ART

A structure such as a motor is required to deal with an increase in output, for example, caused by the expansion of electrification of automobiles. Improving cooling performance is important in increasing the output. In general, in a type of motor that requires high cooling performance, a rise in temperature due to the rotation of a rotor is dealt with by an oil cooling method in which the entirety of a stator is cooled by oil or a water cooling method in which water channels are provided (for example, refer to Patent Document 1).

In a technique disclosed in Patent Document 1, in a rotating electric machine in which a coil concentratedly wound around tooth portions of a stator is accommodated in slots between the tooth portions, a plurality of pipes extending in an axial direction are disposed in parallel in internal spaces of the slots, gaps between the pipes and gaps between the pipes and the coil are filled with a resin material, a resin layer that closes the slots which are open toward an inner peripheral side of the stator is formed, and a refrigerant flows through the pipes.

### RELATED DOCUMENT

### PATENT DOCUMENT

[Patent Document 1] Japanese Patent No. 4496710

### SUMMARY OF THE INVENTION

### TECHNICAL PROBLEM

In a cooling method in which water channels are provided, in the related art, direct cooling the periphery of a coil that is a heat source, such as cooling the vicinities of an outer periphery of electrical steel sheets, cannot be realized, and a new technique has been required. In addition, since an elongated water channel is formed in each slot, pressure loss is likely to occur, and there is a problem in improving cooling performance.

The present invention has been made in view of such circumstances, and an object of the present invention is to provide a technique that improves the cooling performance of a stator.

### SOLUTION TO PROBLEM

According to the present invention, the following techniques are provided.
[1] A stator includes: a yoke portion; tooth portions extending from the yoke portion; a coil accommodated in slots formed between the tooth portions; and a cooling water channel that cools the coil.
   The cooling water channel includes coil inner water channels disposed between one end and the other end in an axial direction to cool the coil, and a header water channel that is connected to a plurality of the coil inner water channels, that is disposed outside the coil, and that distributes cooling water introduced into the coil inner water channels or collects the cooling water discharged from the coil inner water channels.
   When a total cross-sectional area of the coil inner water channels is S1, and a cross-sectional area of a surface of the header water channel, the surface being perpendicular to a movement direction of the cooling water, is S2, a ratio S2/S1 between the S1 and the S2 is equal to or more than 0.5.
[2] In the stator according to [1], the cooling water channel includes a plurality of systems independent of each other.
[3] In the stator according to [1] or [2], the coil inner water channels include slot inner water channels disposed in the respective slots.
[4] In the stator according to any one of [1] to [3], the coil inner water channels include tooth inner water channels disposed in the respective tooth portions.
[5] In the stator according to any one of [1] to [4], the coil inner water channels include yoke inner water channels disposed in the yoke portion.
[6] In the stator according to any one of [1] to [5], each of the coil inner water channels is configured to include a path, which returns the cooling water from the one end to the other end or from the other end to the one end, unit by unit with a plurality of paths as one unit.
[7] In the stator according to any one of [1] to [6], the header water channel includes a header water channel introduction portion that introduces the cooling water from an outside, and a header water channel discharge portion that discharges the cooling water to the outside.
[8] In the stator according to [7], the header water channel introduction portion and the header water channel discharge portion are provided on different sides in the axial direction.
[9] In the stator according to [7], the header water channel introduction portion and the header water channel discharge portion are provided on the same side in the axial direction.
[10] In the stator according to any one of [7] to [9], the number of the header water channel introduction portions and the number of the header water channel discharge portions are the same.
[11] In the stator according to any one of [7] to [9], the number of the header water channel introduction portions and the number of the header water channel discharge portions are different from each other.
[12] In the stator according to any one of [1] to [11], the coil inner water channels and the header water channel are configured to include a resin layer into which a resin composition is cured.
   The resin composition is made of one or two thermosetting resins selected from the group of an epoxy resin and a phenol resin.
[13] In the stator according to any one of [1] to [12], the header water channel adjusts water pressures at portions of the coil inner water channels to be uniform, the portions being connected to the header water channel.
[14] A stator includes: a yoke portion; tooth portions extending from the yoke portion; slots formed between the tooth portions; a coil accommodated in the slots; and a cooling water channel that cools the coil.
   The cooling water channel is disposed between one end and the other end of the yoke portion in an axial direction, and is configured to include a path, which returns cooling water from the one end to the other end or from the other end to the one end, unit by unit with a plurality of paths as one unit.
[15] In the stator according to claim 14, the number of paths is different between external cooling water introduction paths that introduce the cooling water and external cooling water discharge paths connected to discharge the cooling water.
[16] A structure includes: the cooling water channel included in the stator according to any one of [1] to [15]; and a power module cooling water channel that is connected to the cooling water channel, and that cools a power module included in an inverter provided integrally with a motor including the stator.
[17] In the structure according to [16], the power module cooling water channel cools a semiconductor element circuit included in the power module.
[18] In the structure according to [16] or [17], the power module cooling water channel cools a capacitor included in the inverter.

### ADVANTAGEOUS EFFECTS OF INVENTION

According to the present invention, it is possible to provide a technique that improves the cooling performance of the stator.

### BRIEF DESCRIPTION OF THE DRAWINGS

Fig. 1 is a perspective view of a motor unit according to a first embodiment.
Fig. 2 is a partial cross-sectional view of a stator according to the first embodiment.
Fig. 3 is a perspective view of a first cooling flow channel according to the first embodiment.
Fig. 4 is a schematic view describing the first cooling flow channel according to the first embodiment.
Fig. 5 is a cross-sectional view schematically showing an internal structure of an inverter unit according to the first embodiment.
Fig. 6 is a perspective view schematically showing a base portion with an inverter circuit disposed thereon according to the first embodiment.
Fig. 7 is a perspective view schematically showing a state where the inverter circuit and a water channel lid portion of Fig. 6 are removed, according to the first embodiment.
Fig. 8 is a schematic view describing a first cooling flow channel according to a second embodiment.
Fig. 9 is a perspective view of a first cooling flow channel according to a third embodiment.
Fig. 10 is a schematic view describing a first cooling flow channel according to the third embodiment.
Fig. 11 is a perspective view of a first split cooling flow channel of a first cooling flow channel according to a fourth embodiment.
Fig. 12 is a perspective view of a first split cooling flow channel of a first cooling flow channel according to a fifth embodiment.
Fig. 13 is a schematic view describing a first cooling flow channel according to the fifth embodiment.

### DESCRIPTION OF EMBODIMENTS

### <Outline>

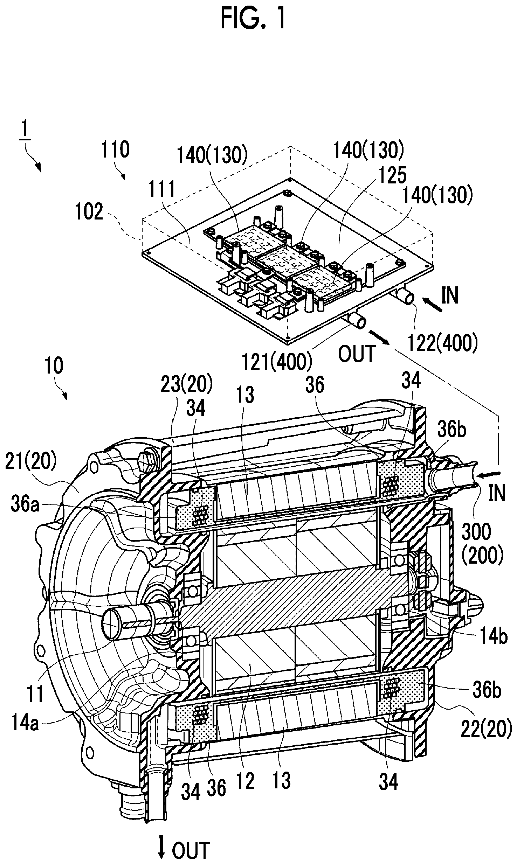

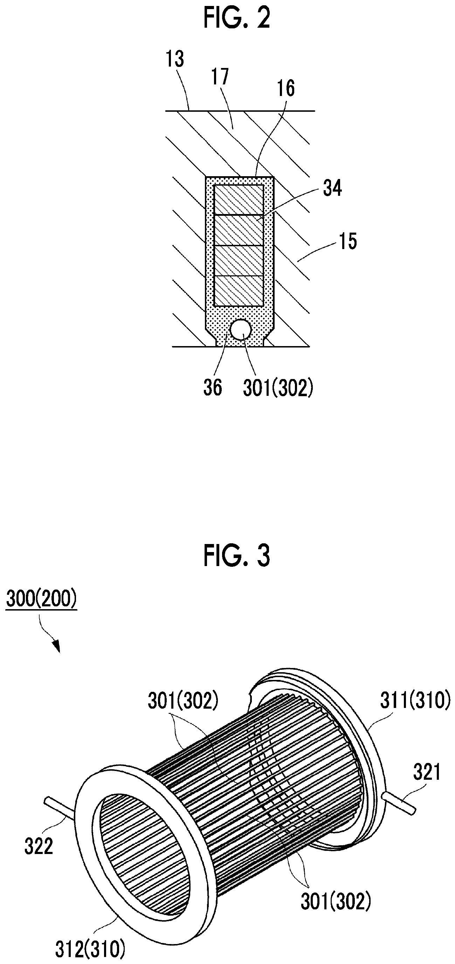

In the present embodiment, an example in which the present invention is applied to an inverter motor as a rotating electric machine (an electric motor, a generator, or a hybrid electric motor-generator) will be described. Fig. 1 is a perspective view of a motor unit 1, and is shown as a partial cross-sectional view. Fig. 2 schematically shows a cross-sectional view taken along a plane perpendicular to a rotating shaft of a motor 10. Here, the region of one slot 16 is shown in a cross-sectional view taken along a plane perpendicular to a shaft 11.

### <Structure of motor unit 1>

The motor unit 1 includes the motor 10 and an inverter unit 100 (inverter device) attached to the motor 10, and these components are cooled by a cooling flow channel 200. The cooling flow channel 200 includes a first cooling flow channel 300 that mainly cools the motor 10, and a second cooling flow channel 400 that mainly cools the inverter unit 100.

### <Motor 10>

The motor 10 includes a housing 20, and a rotor 12 and a stator 13 accommodated in the housing 20. The shaft 11 is attached to the center of the rotor 12 as an output shaft. The shaft 11 is rotatably supported by left and right bearings 14a and 14b.

### <Housing 20>

The housing 20 includes a first housing cover 21, a second housing cover 22, and a third housing cover 23.

The third housing cover 23 is a housing case having a cylindrical shape, and accommodates the rotor 12 and the stator 13 therein. In this case, the stator 13 is attached to an inner peripheral surface of the third housing cover 23.

The first housing cover 21 is provided in a substantially disk shape, and closes an end portion opening of the third housing cover 23 having a cylindrical shape on the left side of the drawing in an axial direction. A through-hole 24 having a circular shape, through which the shaft 11 is allowed to protrude, is provided at the center of the first housing cover 21. The bearing 14a is attached to the center of an inner surface (surface on the left side of the drawing) of the first housing cover 21 to rotatably support the shaft 11.

The second housing cover 22 is provided in a substantially disk shape, and closes an end portion opening of the third housing cover 23 having a cylindrical shape on the right side of the drawing in the axial direction. The bearing 14b is attached to the center of an inner surface (surface on the right side of the drawing) of the second housing cover 22 to rotatably support the shaft 11.

The material of the bearings 14a and 14b is, for example, high-carbon chrome bearing steel, stainless steel, or the like, and in general, materials standardized by JIS standards and the like are used.

### <Shaft 11>

The shaft 11 has a substantially columnar shape, and is fixed to the center of the rotor 12 as described above. One (the left side of the drawing) end portion of the shaft 11 is rotatably supported by one bearing 14a. The other end portion of the shaft 11 is rotatably supported by the other bearing 14b. The material of the shaft 11 is, for example, carbon steel, and in general, materials defined by JIS are used.

### <Rotor 12>

A plurality of permanent magnets disposed inside at equal intervals in a circumferential direction of the shaft are disposed in the rotor 12. In this case, the magnetic poles of the permanent magnets adjacent to each other are disposed to be different from each other.

### <Stator 13>

The stator 13 has a substantially cylindrical shape, and is disposed and fixed to an inner periphery of the housing 20 (more specifically, the third housing cover 23) so as to surround an outer periphery of the rotor 12. A very small gap (air gap) is provided between an inner peripheral surface of the stator 13 and an outer peripheral surface of the rotor 12.

The stator 13 is formed by laminating a plurality of electrical steel sheets that are thin plate-shaped magnetic bodies. The stator 13 includes a yoke portion 17 having a cylindrical shape and a plurality of tooth portions 15 arranged from the yoke portion 17 toward a rotor 12 side. A space called the slot 16 is provided between the tooth portions 15.

A coil 34 (for example, distributed wound) is accommodated in the slot 16, and a high thermal conductive resin sealing portion 36 filled together with the coil 34 is provided in the slot 16.

The tooth portions 15 are provided to correspond to the permanent magnets of the rotor 12 described above, and by sequentially exciting each coil 34, the rotor 12 rotates due to attraction to and repulsion against the permanent magnet corresponding thereto.

The high thermal conductive resin sealing portion 36 is provided to extend in a rotating shaft direction with respect to the outside of the stator 13. Both end portions 36a and 36b of the high thermal conductive resin sealing portion 36 in the axial direction come into contact with the first cooling flow channel 300 (header water channel 310) to be described later which includes the first and second housing covers 21 and 22 as parts of components. As a result, the heat of the high thermal conductive resin sealing portion 36, namely, the heat of the coil 34 can be reliably transferred to the first cooling flow channel 300 (header water channel 310).

Inside each slot 16, the first cooling flow channel 300 (coil inner water channel 301) is provided to extend in the axial direction in a region where the high thermal conductive resin sealing portion 36 is provided. The first cooling flow channel 300 effectively dissipates heat generated by the coil 34 using a refrigerant that flows through the first cooling flow channel 300. In the present embodiment, a configuration in which cooling water is used as the refrigerant will be provided as an example.

A method for molding the high thermal conductive resin sealing portion 36 is not particularly limited, and insert molding can be used. In this case, the high thermal conductive resin sealing portion 36 and the first cooling flow channel 300 having a desired structure can be created by disposing a mold structure (insert structure) corresponding to the first cooling flow channel 300 in the slot in which the distributed wound coil 34 is disposed, and by performing insert molding. In the present embodiment, the coil inner water channel 301 is formed on the rotor 12 side (the lower side in Fig. 2) with respect to the coil 34 inside the slot 16, but is not limited thereto, and may be provided between the coil 34 and the yoke portion 17.

The transfer of heat can be facilitated by replacing a space around the coil 34 (namely, the slot) with the high thermal conductive resin sealing portion 36 (resin material). Namely, the coil 34 and the stator 13 are tightly filled with a resin material. Furthermore, an inner wall 10a of the first cooling flow channel 300 is formed from the resin material. Therefore, thermal conduction therebetween is improved. Accordingly, the cooling performance of the stator 13 can be improved, a copper loss (a loss that is consumed due to the resistance of the coil 34 itself) can be reduced, and an improvement in motor output, the downsizing of the motor unit 1, and the like can be achieved.

### <Cooling flow channel 200>

The cooling flow channel 200 includes a first cooling flow channel 300 that mainly cools the motor 10, and a second cooling flow channel 400 that mainly cools the inverter unit 100. The second cooling flow channel 400 will be described together with the description of the inverter unit 100 to be described later.

### <First cooling flow channel 300>

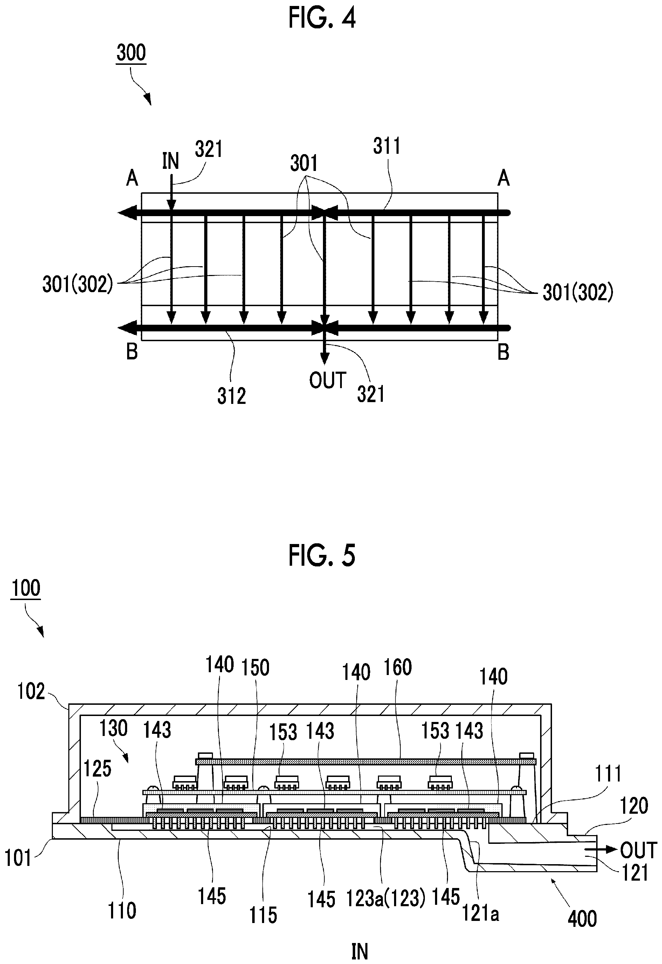

Fig. 3 is a perspective view of the first cooling flow channel 300. Fig. 4 is a schematic view describing the first cooling flow channel 300, and is shown as an unfolded view. In Fig. 4, reference signs A indicate a coincident position, and reference signs B indicate a coincident position.

The first cooling flow channel 300 includes a plurality of the coil inner water channels 301 and the header water channel 310. In the first cooling flow channel 300, a part of the configuration of the high thermal conductive resin sealing portion 36 is provided as a water channel wall surface, but a part of another component may be provided as a water channel wall surface.

### <Coil inner water channels 301>

The coil inner water channel 301 is disposed between one end and the other end in the axial direction to cool the coil 34. Specifically, in the high thermal conductive resin sealing portion 36 inside each slot 16, the coil inner water channel 301 uses the wall surface of the high thermal conductive resin sealing portion 36 as a water channel wall surface, and is provided in a tubular shape along the coil 34 between a first header water channel 311 and a second header water channel 312. In addition, as the coil inner water channel 301, a tubular member made of a highly thermal conductive non-magnetic metal such as aluminum or an aluminum alloy or a highly thermal conductive inorganic material can be used. In addition, the coil inner water channels 301 may be provided in all the slots 16 or may be provided in some slots 16 (for example, every other slot) .

### <Structure of header water channel 310>

The header water channel 310 is connected to the plurality of coil inner water channels 301, is disposed outside the coil, and distributes the cooling water introduced into the coil inner water channels 301 or collects the cooling water discharged from the coil inner water channels 301. Namely, the header water channel 310 adjusts water pressures at portions of the coil inner water channels 301 to be uniform, the portions being connected to the header water channel 310.

Specifically, the header water channel 310 includes the first header water channel 311 and the second header water channel 312. The first header water channel 311 and the second header water channel 312 are disposed to face each other with the stator 13 interposed (yoke portion 17) therebetween.

The first header water channel 311 is disposed on an upstream side of the coil inner water channels 301, and has a function of temporarily storing the cooling water introduced into the coil inner water channels 301 and distributing the cooling water to the plurality of coil inner water channels 301. The first header water channel 311 is provided in an annular shape so as to face one end portion the yoke portion 17, and a water channel through which the cooling water flows is formed thereinside. The coil inner water channels 301 are attached to the first header water channel 311 at regular intervals in the circumferential direction so as to face the second header water channel 312. In addition, the first header water channel 311 is provided with an introduction connection portion 321 (header water channel introduction portion) that takes in the cooling water from the outside (for example, a pump).

The second header water channel 312 is disposed on a downstream side of the coil inner water channels 301, and collects and temporarily stores the cooling water discharged from the coil inner water channels 301 and discharges the cooling water to the outside. The second header water channel 312 is provided in an annular shape so as to face the other end portion of the yoke portion 17, and a water channel through which the cooling water flows is formed thereinside. The coil inner water channels 301 are attached to the second header water channel 312 at regular intervals in the circumferential direction so as to face the first header water channel 311. In addition, the second header water channel 312 is provided with a discharge connection portion 322 (header water channel discharge portion) that sends the cooling water to the outside (for example, the pump).

Here, the number of the introduction connection portions 321 (header water channel introduction portions) and the number of the discharge connection portions 322 (header water channel discharge portions) are the same, but may be different from each other. For example, by increasing the number of the discharge connection portions 322 (header water channel discharge portions), the cooling water is smoothly discharged, so that the retention of the cooling water can be suppressed.

### <Cross-sectional area of header water channel 310 and coil inner water channel 301>

When the total cross-sectional area of the plurality of coil inner water channels 301 is S1, and the cross-sectional area of a surface of the header water channel 310 (the first header water channel 311 and the second header water channel 312), the surface being perpendicular to a movement direction of the cooling water, is S2, a ratio S2/S1 between S2 and S1 is equal to or more than 0.5. Here, the movement direction of the cooling water can also be said to be an "extending direction (disposition direction) of the header water channel 310". The ratio S2/S1 is preferably equal to or more than 0.7, more preferably equal to or more than 1.0. The cross-sectional area S2 of the header water channel 310 satisfies the ratio S2/S1 in the cross-sectional area of at least one of the first header water channel 311 and the second header water channel 312; however, it is preferable that the cross-sectional area S2 satisfies the ratio S2/S1 in the cross-sectional areas of both the first header water channel 311 and the second header water channel 312. When the cross-sectional areas S1 and S2 are not constant, it is preferable that the smallest value of each of the cross-sectional areas S1 and S2 is used.

In general, when an elongated water channel such as the coil inner water channel 301 is formed in each slot 16, pressure loss is likely to occur, and when the cooling water is distributed to the plurality of coil inner water channels 301, it is assumed that the cooling performance differs depending on the coil inner water channels 301. Therefore, as in the present embodiment, by setting the range of the ratio S2/S1 as described above, the cooling water is allowed to flow in a well-balanced manner, and the pressure loss can be suppressed to a level that does not affect the cooling performance. As a result, there is no need to increase the pump pressure, so that the load on the first cooling flow channel 300 can be suppressed, and the degree of freedom in designing the flow channels is increased.

As an example of the coil inner water channel 301, a slot inner water channel 302 provided inside the slot 16, more specifically, inside the high thermal conductive resin sealing portion 36 has been provided; however, the present invention is not limited thereto, tooth inner water channels disposed inside the tooth portions 15 may be provided, or yoke inner water channels disposed inside the yoke portion 17 may be provided.

In addition, the introduction connection portion 321 (header water channel introduction portion) and the discharge connection portion 322 (header water channel discharge portion) are provided on different sides in the axial direction, namely, on the first header water channel 311 and the second header water channel 312 located on different sides with the stator 13 interposed therebetween. The present invention is not limited to this configuration, and the introduction connection portion 321 (header water channel introduction portion) and the discharge connection portion 322 (header water channel discharge portion) may be provided on the same side in the axial direction. In this case, for example, the first header water channel 311 may be split into a configuration for introducing the cooling water and a configuration for discharging the cooling water, and the water channels may be configured to return at the second header water channel 312.

### <Inverter unit 100>

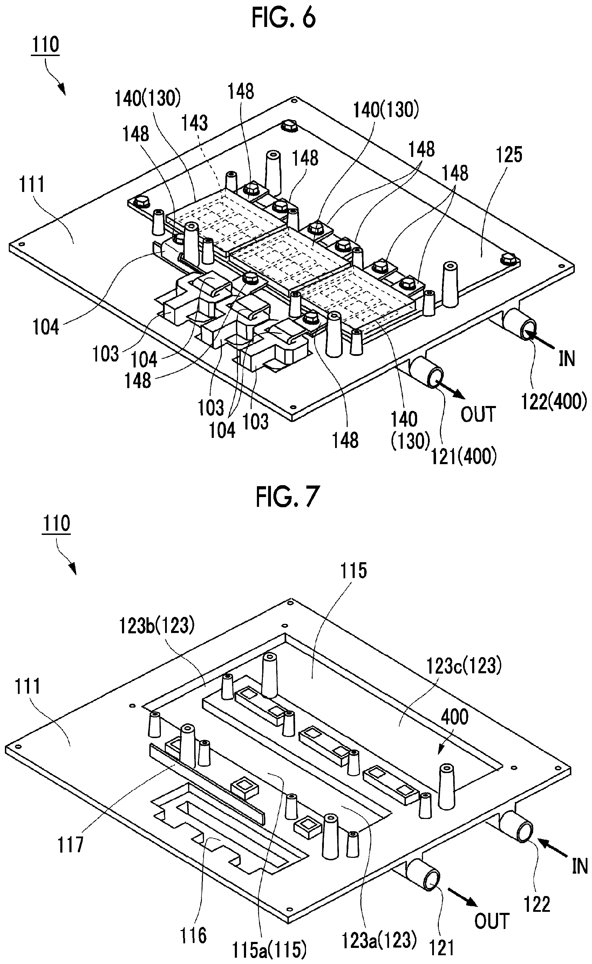

The inverter unit 100 is shown in Figs. 5 to 7. Fig. 5 is a cross-sectional view schematically showing an internal structure of the inverter unit 100. Fig. 6 is a perspective view schematically showing a base portion 101 with an inverter circuit 130 disposed thereon. Fig. 7 is a perspective view schematically showing a state where the inverter circuit 130 and a water channel lid portion 125 of Fig. 6 are removed. In the present embodiment, the cooling function will be mainly described, and a general configuration of the inverter device is not shown as appropriate.

The inverter unit 100 is attached to the motor 10 of an inverter drive type. The inverter unit 100 includes an inverter case 110 having a substantially box shape and made of a resin composition; the inverter circuit 130 accommodated inside; and the second cooling flow channel 400 that cools the inverter circuit 130 (particularly, a power module 140). The inverter circuit 130 includes the power module 140 and other components (first and second circuit boards 150 and 160, a current sensor 103, and the like).

Hereinafter, each configuration will be specifically described.

### <Inverter case 110>

The inverter case 110 includes the base portion 101 having a plate shape and a cover portion 102 having a rectangular parallelepiped shape of which a bottom portion covering the base portion 101 is open, and these components are fixed by screws or the like. The inverter circuit 130 is provided inside the inverter case 110.

### <Inverter circuit 130>

The inverter circuit 130 includes the power module 140, the first circuit board 150, and the second circuit board 160. The power module 140 includes a semiconductor chip 143; a heat dissipation member 145 made of metal and attached to a lower surface of the semiconductor chip 143; and a lead frame 148 connected to the semiconductor chip 143, and is sealed with resin.

### <Base portion 101>

The base portion 101 has a substantially rectangular shape when seen in a top view, and is provided in a plate shape by integral molding.

The base portion 101 uses a surface on the upper side of the drawing as a board disposition surface 111, and components such as the inverter circuit 130, the first and second circuit boards 150 and 160, and the current sensor 103 (bus bar 104) are attached to the board disposition surface 111. The board disposition surface 111 integrally includes a water channel wall 115 formed in a recessed shape and forming a part of the second cooling flow channel 400, and a component disposition portion 116 on which the current sensor 103 and the like are disposed.

### <Second cooling flow channel 400/Water channel wall 115>

The second cooling flow channel 400 is formed by the water channel wall 115 in which the board disposition surface 111 is formed in a recessed shape, and the water channel lid portion 125 provided to cover an upper surface of the water channel wall 115. For example, the water channel lid portion 125 is provided in a plate shape using metal such as an aluminum alloy or a resin material. Since the water channel lid portion 125 has a function of sealing the cooling water, and has a function of transferring heat from various devices disposed on the water channel lid portion 125, an aluminum alloy is preferable from the viewpoints of thermal conduction, weight reduction, and anti-corrosion. In addition, in the case of using a resin material, a material having a high thermal conductivity is preferable. A packing, a seal material, or the like required to prevent leakage of the cooling water is appropriately disposed between the water channel lid portion 125 and the board disposition surface 111.

The second cooling flow channel 400 includes a first water channel connection port 121, a second water channel connection port 122, and a flow channel main body 123.

The flow channel main body 123 is provided in an approximately U shape as a whole, and includes a first flow channel 123a extending in a left-right direction in a drawing view, a second flow channel 123b extending in a front-rear direction, and a third flow channel 123c extending in the left-right direction.

The flow channel main body 123 is provided with the water channel lid portion 125 made of resin and having a plate shape, and the flow channel main body 123 is sealed on an upper surface of the board disposition surface 111. A plurality (here, three) of the power modules 140 are attached to a portion of the water channel lid portion 125, which serves as the first flow channel 123a. In addition, a film capacitor (not shown) or other electronic components are disposed in the portion of the third flow channel 123c.

Openings penetrating up and down through the water channel lid portion 125 are provided in regions of the water channel lid portion 125, to which the power modules 140 are attached, and the heat dissipation members 145 having a pin shape and provided on lower surfaces of the power modules 140 extend from the openings into the first flow channel 123a. As a result, the heat dissipation members 145 of the power modules 140 are directly cooled by the cooling water. The shape of the heat dissipation members 145 is not limited to a pin shape, and may be a fin shape, and various shapes can be adopted as long as the heat dissipation members 145 can be cooled by the cooling water.

The first water channel connection port 121 is connected to the first cooling flow channel 300. The second water channel connection port 122 functions as an introduction port of the cooling water.

The first water channel connection port 121 and the second water channel connection port 122 are disposed side by side on a right side surface of the base portion 101, and are connected to the first flow channel 123a and the third flow channel 123c, respectively. More specifically, the first water channel connection port 121 extends in a pipe shape from the lower side of the right side surface of the base portion 101 toward the left side, bends in an upward direction at a connection portion 121a, and is connected to the flow channel main body 123 (first flow channel 123a). The second water channel connection port 122 is also connected to the third flow channel 123c by the same configuration as the first water channel connection port 121.

According to the configuration of the second cooling flow channel 400 described above, the cooling water introduced from the second water channel connection port 122 passes through the flow channel main body 123 (the first to third flow channels 123a to 123c) to cool the power modules 140, the film capacitor, and the like, and is supplied from the first water channel connection port 121 to the first cooling flow channel 300. The inverter unit 100 and the motor 10 may be cooled through respective independent paths. Namely, the flow channels of the first cooling flow channel 300 and the second cooling flow channel 400 may be provided independently of each other without being connected.

### <Material of inverter case 110>

The inverter case 110 is made of a third resin composition. Specifically, the third resin composition is a thermosetting resin, and is made of, for example, a phenol resin or an epoxy resin. The base portion 101 and the cover portion 102 constituting the inverter case 110 are formed from a cured product of a thermosetting resin. The base portion 101 and the cover portion 102 may be formed from the same material or may be formed from different materials. Specifically, as the thermosetting resin, the same material as the first resin composition or the second resin composition described above can be used.

The inverter case 110 (the base portion 101 or the cover portion 102) is made of resin, so that adhesion to the other members can be improved and a weight reduction can be achieved. In addition, the moldability and processability are made good by using resin, so that the degree of freedom in designing can be greatly increased, vibration can be absorbed, and noise can be reduced.

The content of fillers contained in the thermosetting resin is equal to or more than 60% by volume, preferably equal to or more than 70%. As a result, a further weight reduction and high mechanical strength can be achieved.

Various embodiments (modification examples) of the cooling flow channel 200 can be adopted. Hereinafter, such embodiments will be described. In the following description, different configurations and functions of the first cooling flow channel 300 will be mainly described, and the description of other configurations and functions will not be repeated as appropriate.

### <<Second embodiment>>

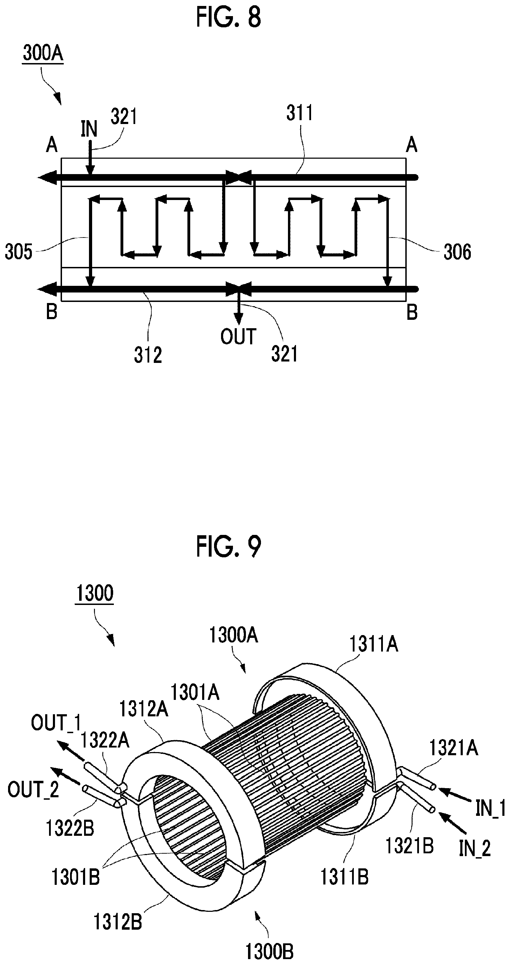

A first cooling flow channel 300A of the cooling flow channel 200 of the present embodiment will be described with reference to Fig. 8. Fig. 8 is a schematic view describing the first cooling flow channel 300A. The first cooling flow channel 300A includes a first header water channel 311A and a second header water channel 312A. The first cooling flow channel 300A includes two water channel (coil inner water channel) systems from the first header water channel 311A toward the second header water channel 312A, namely, a first coil inner return water channel 305 and a second coil inner return water channel 306.

The first coil inner return water channel 305 passes through the inside of the slots 16 (inside of the high thermal conductive resin sealing portions 36) in a so-called unicursal shape, returns a predetermined number of times without being connected to the first header water channel 311 or the second header water channel 312 at locations where the first coil inner return water channel 305 exits the slots 16, and is finally connected to the second header water channel 312. Similarly, the second coil inner return water channel 306 also passes through the inside of the slots 16 (inside of the high thermal conductive resin sealing portion 36) in a so-called unicursal shape, returns a predetermined number of times without being connected to the first header water channel 311 or the second header water channel 312 at locations where the second coil inner return water channel 306 exits the slots 16, and is finally connected to the second header water channel 312.

In this configuration as well, when the total cross-sectional area of a plurality of the coil inner water channels (namely, the first coil inner return water channel 305 and the second coil inner return water channel 306) is S1, and the cross-sectional area of a surface of a header water channel 310 (the first header water channel 311 and the second header water channel 312), the surface being perpendicular to a movement direction of the cooling water, is S2, the ratio S2/S1 between S2 and S1 is equal to or more than 0.5. As a result, the cooling water flows in a well-balanced manner, and the pressure loss can be suppressed to a level that does not affect the cooling performance. In addition, by providing the two water channel systems as the return water channels, redundancy can be ensured even when a defect occurs in one water channel system. Three or more water channel systems may be provided as the return water channels.

### <<Third embodiment>>

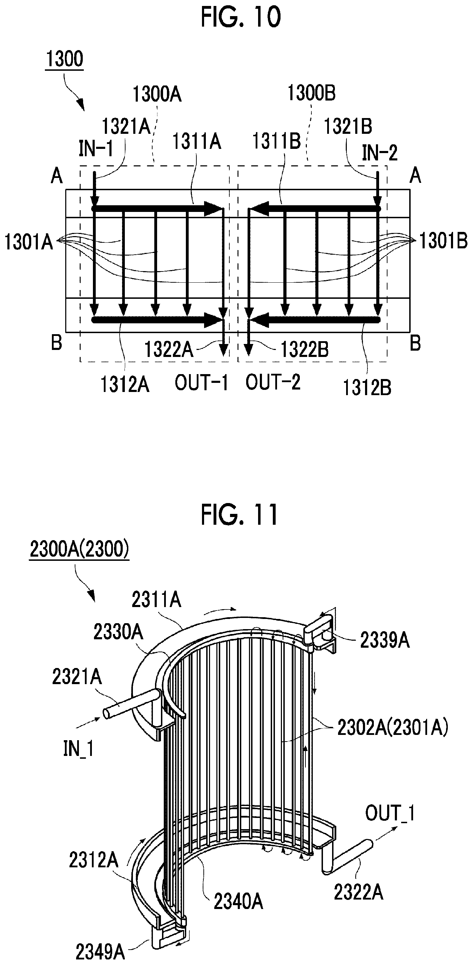

A first cooling flow channel 1300 will be described with reference to Figs. 9 and 10. Fig. 9 is a perspective view of the first cooling flow channel 1300. Fig. 10 is a schematic view describing the first cooling flow channel 1300, and is shown as an unfolded view. In Fig. 10, reference signs A indicate a coincident position, and reference signs B indicate a coincident position.

The first cooling flow channel 1300 includes a first split cooling flow channel 1300A and a second split cooling flow channel 1300B. The first split cooling flow channel 1300A and the second split cooling flow channel 1300B are formed of water channels independent of each other. It can also be said that this configuration is obtained by vertically splitting the first cooling flow channel 300 of the first embodiment into two cooling flow channels.

The first split cooling flow channel 1300A includes a first header water channel 1311A having a semi-arc shape, a second header water channel 1312A having a semi-arc shape, and a plurality of coil inner water channels 1301A. The first header water channel 1311A and the second header water channel 1312A are disposed to face each other with the stator 13 interposed therebetween.

The first header water channel 1311A is disposed on an upstream side of the coil inner water channels 1301A, and has a function of temporarily storing the cooling water introduced into the coil inner water channels 1301A and distributing the cooling water to the plurality of coil inner water channels 1301A. The coil inner water channels 1301A are attached to the first header water channel 1311A at regular intervals in the circumferential direction so as to face the second header water channel 1312A. In addition, the first header water channel 1311A is provided with an introduction connection portion 1321A that takes in the cooling water from the outside.

The second header water channel 1312A is disposed on a downstream side of the coil inner water channels 1301A, and collects and temporarily stores the cooling water discharged from the coil inner water channels 1301A and discharges the cooling water to the outside. The coil inner water channels 1301A are attached to the second header water channel 1312A at regular intervals in the circumferential direction so as to face the first header water channel 1311A. In addition, the second header water channel 1312A is provided with a discharge connection portion 1322A that sends the cooling water to the outside.

The second split cooling flow channel 1300B includes a first header water channel 1311B having a semi-arc shape, a second header water channel 1312B having a semi-arc shape, and a plurality of coil inner water channels 1301B. The first header water channel 1311B and the second header water channel 1312B are disposed to face each other with the stator 13 interposed therebetween.

The first header water channel 1311B is disposed on an upstream side of the coil inner water channels 1301B, and has a function of temporarily storing the cooling water introduced into the coil inner water channels 1301B and distributing the cooling water to the plurality of coil inner water channels 1301B. The coil inner water channels 1301B are attached to the first header water channel 1311B at regular intervals in the circumferential direction so as to face the second header water channel 1312B. In addition, the first header water channel 1311B is provided with an introduction connection portion 1321B that takes in the cooling water from the outside.

The second header water channel 1312B is disposed on a downstream side of the coil inner water channels 1301B, and collects and temporarily stores the cooling water discharged from the coil inner water channels 1301B and discharges the cooling water to the outside. The coil inner water channels 1301B are attached to the second header water channel 1312B at regular intervals in the circumferential direction so as to face the first header water channel 1311B. In addition, the second header water channel 1312B is provided with a discharge connection portion 1322B that sends the cooling water to the outside.

In the first split cooling flow channel 1300A as well, the total cross-sectional area of the plurality of coil inner water channels 1301A is S1, and the cross-sectional area of a surface of a header water channel 1310 (the first header water channel 1311A and the second header water channel 1312A), the surface being perpendicular to a movement direction of the cooling water, is S2, the ratio S2/S1 between S2 and S1 is equal to or more than 0.5. Similarly, regarding the second split cooling flow channel 1300B, the ratio S2/S1 is equal to or more than 0.5. As a result, the cooling water flows in a well-balanced manner, and the pressure loss can be suppressed to a level that does not affect the cooling performance.

The first cooling flow channel 1300 includes the first split cooling flow channel 1300A and the second split cooling flow channel 1300B that are formed of water channel systems independent of each other. As a result, redundancy can be provided to deal with a trouble with a possible water channel trouble (blocking or the like). Namely, even when a defect occurs in one water channel system, cooling is performed by the other water channel system, so that the motor unit 1 is not stopped immediately. Namely, operation can be performed in a low heat generation state due to a low load for a certain period. For example, in a case where the motor unit 1 is mounted on a vehicle, the vehicle can move by itself to a location where the vehicle can be repaired.

### <<Fourth embodiment>>

A first cooling flow channel 2300 of the present embodiment will be described with reference to Fig. 11. Similarly to the third embodiment, the first cooling flow channel 2300 includes two water channel systems formed by vertically splitting the first cooling flow channel 2300 into two cooling flow channels, and hereinafter, a first split cooling flow channel 2300A that is one water channel system will be described, and the other water channel system (second split cooling flow channel) will not be described.

The first split cooling flow channel 2300A includes a first header water channel 2311A having a semi-arc shape, a second header water channel 1312A having a semi-arc shape, and a coil inner water channel 2301A.

An introduction connection portion 2321A is provided at one end portion of the first header water channel 2311A having a semi-arc shape. The first header water channel 2311A and the coil inner water channel 2301A are connected by a first connection portion 2339A at the other end portion of the first header water channel 2311A having a semi-arc shape.

A discharge connection portion 2322A is provided at one end portion (a side on which the first connection portion 2339A is provided) of the second header water channel 2312A having a semi-arc shape. The second header water channel 2312A and the coil inner water channel 2301A are connected by a second connection portion 2349A at the other end portion (a side on which the introduction connection portion 2321A is provided) of the second header water channel 2312A having a semi-arc shape. The second header water channel 1312A and the coil inner water channel 2301A are connected by the second connection portion 2349A.

The coil inner water channel 2301A includes slot inner water channels 2302A provided in the respective slots 16, and a first return portion 2330A and a second return portion 2340A that cause the slot inner water channels 2302A to return in a unicursal shape in regions protruding from the slots 16. At the first return portion 2330A and the second return portion 2340A, connections between the slot inner water channels 2302A are provided at every other slot due to the characteristic of the structure in which returning is performed in a unicursal shape. Further, the first return portion 2330A and the second return portion 2340A may be configured to be provided only at portions where the slot inner water channels 2302A are connected and not to be provided at portions where the slot inner water channels 2302A are not connected.

### <<Fifth embodiment>>

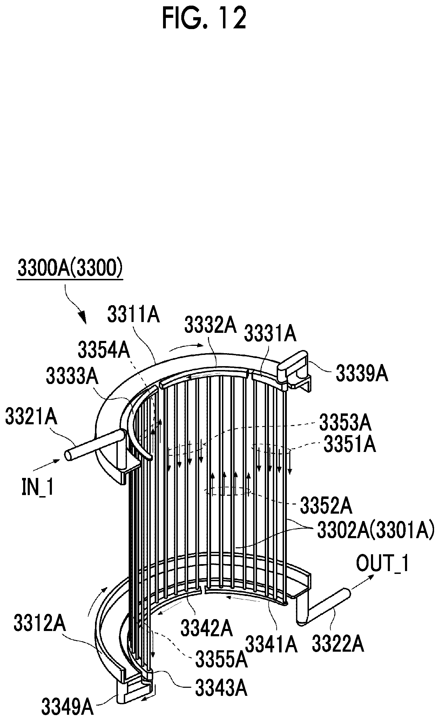

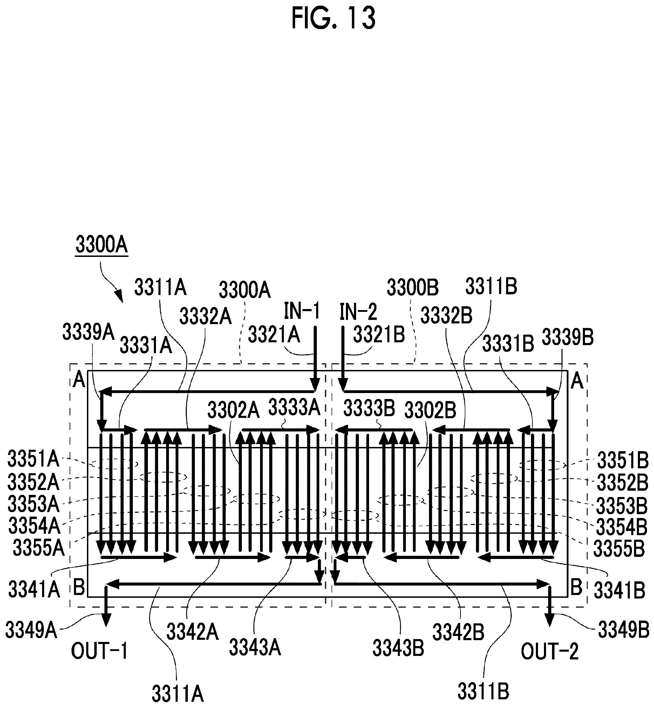

A first cooling flow channel 3300 of the present embodiment will be described with reference to Figs. 12 and 13.

Fig. 12 is a perspective view of a first split cooling flow channel 3300A of the first cooling flow channel 3300. Fig. 13 is a schematic view describing the first cooling flow channel 3300, and is shown as an unfolded view. In Fig. 13, reference signs A indicate a coincident position, and reference signs B indicate a coincident position.

The first cooling flow channel 3300 of the present embodiment is a modification example of the first cooling flow channel 2300 of the fourth embodiment, and a coil inner water channel 3301A is configured to include a path, which returns the cooling water from the one end to the other end or the other end to the one end, unit by unit with a plurality of paths as one unit. Here, paths are configured by using four slot inner water channels 3302A as one unit.

In the first split cooling flow channel 3300A, the cooling water introduced into a first header water channel 3311A from an introduction connection portion 3321A is introduced into a first upstream return portion 3331A through a first connection portion 3339A. Four slot inner water channels 3302A (also referred to as a first return unit 3351A) from the first upstream return portion 3331A toward a first downstream return portion 3341A are connected to consolidate the water channels.

The first return unit 3351A is connected to the first downstream return portion 3341A, and four slot inner water channels 3302A (also referred to as a second return unit 3352A) toward a second upstream return portion 3332A are connected to the first downstream return portion 3341A.

The second return unit 3352A is connected to the second upstream return portion 3332A, and four slot inner water channels 3302A (also referred to as a third return unit 3353A) toward a second downstream return portion 3342A are connected to the second upstream return portion 3332A.

The third return unit 3353A is connected to the second downstream return portion 3342A, and four slot inner water channels 3302A (also referred to as a fourth return unit 3354A) toward a third upstream return portion 3333A are connected to the second downstream return portion 3342A.

The third return unit 3354A is connected to the third upstream return portion 3333A, and four slot inner water channels 3302A (also referred to as a fifth return unit 3355A) toward a third downstream return portion 3343A are connected to the third upstream return portion 3333A.

A second header water channel 3312A is connected to the third downstream return portion 3343A through a second connection portion 3349A. A discharge connection portion 3322A is connected to an end portion on an opposite side of the second header water channel 3312A from the second connection portion 3349A.

Similarly, regarding a second split cooling flow channel 3300B, first to fourth return units 3351B to 3354B, each having four slot inner water channels 3302A as one unit, are provided between a first header water channel 3311B and a second header water channel 3312B.

The cooling water introduced into the first header water channel 3311B from an introduction connection portion 3321B is introduced into a first upstream return portion 3331B through a first connection portion 3339B, and is sent to a first downstream return portion 3341B through four slot inner water channels 3302B (first return unit 3351B).

At the first downstream return portion 3341B, the water channels are once consolidated and distributed to four slot inner water channels 3302B (also referred to as a second return unit 3352B) toward a second upstream return portion 3332B.

At the second upstream return portion 3332B, the water channels are once consolidated in the same manner, and are distributed to four slot inner water channels 3302B (third return unit 3353B) toward a second downstream return portion 3342B.

At the second downstream return portion 3342B, the water channels are once consolidated in the same manner, and are distributed to four slot inner water channels 3302B (fourth return unit 3354B) toward a third upstream return portion 3333B.

At the third upstream return portion 3333B, the water channels are once consolidated in the same manner, and are distributed to four slot inner water channels 3302B (fifth return unit 3355B) toward a third downstream return portion 3343B.

The water channels consolidated by the third downstream return portion 3343B are connected to a discharge connection portion 3322B through a second connection portion 3349B and the second header water channel 3312B.

The embodiments of the present invention have been described above, and these embodiments are examples of the present invention, and various configurations other than those described above can be adopted.

This application claims priority based on Japanese Patent Application No. 2021-175415 filed on October 27, 2021, the entire disclosure of which is herein incorporated by reference.

### REFERENCE SIGNS LIST

1 motor unit
10 motor
12 rotor
13 stator
15 tooth portion
16 slot
17 yoke portion
20 housing
34 coil
36 high thermal conductive resin sealing portion
100 inverter unit
101 base portion
102 cover portion
123 flow channel main body
130 inverter circuit
140 power module
143 semiconductor chip
200 cooling flow channel
300, 300A, 1300, 2300, 3300 first cooling flow channel
301, 1301A, 1301B, 2301A, 3301A coil inner water channel
302, 2302A, 3302A, 3302B slot inner water channel
305 first coil inner return water channel
306 second coil inner return water channel
310, 1310 header water channel
311, 311A, 1311A, 1311B, 2311A, 3311A, 3311B first header water channel
312, 312A, 1312A, 1312B, 2312A, 3312A, 3312B second header water channel
321, 1321A, 1321B, 2321A, 3321A, 3321B introduction connection portion
322, 1322A, 1322B, 2322A, 3322A, 3321B discharge connection portion
400 second cooling flow channel
1300A, 2300A, 3300A first split cooling flow channel
1300B, 3300B second split cooling flow channel
3331A, 3331B first upstream return portion
3332A, 3332B second upstream return portion
3333A, 3333B, third upstream return portion
3341A, 3341B first downstream return portion
3342A, 3342B second downstream return portion
3343A, 3343B, third downstream return portion
3351A, 3351B first return unit
3352A, 3352B second return unit
3353A, 3353B third return unit
3354A, 3354B fourth return unit
3355A, 3355B fifth return unit

## Claims

1. A stator comprising:
a yoke portion;
tooth portions extending from the yoke portion;
a coil accommodated in slots formed between the tooth portions; and
a cooling water channel that cools the coil,
wherein the cooling water channel includes coil inner water channels disposed between one end and the other end in an axial direction to cool the coil, and a header water channel that is connected to a plurality of the coil inner water channels, that is disposed outside the coil, and that distributes cooling water introduced into the coil inner water channels or collects the cooling water discharged from the coil inner water channels, and
when a total cross-sectional area of the coil inner water channels is S1, and a cross-sectional area of a surface of the header water channel, the surface being perpendicular to a movement direction of the cooling water, is S2, a ratio S2/S1 between the S1 and the S2 is equal to or more than 0.5.

2. The stator according to claim 1,
wherein the cooling water channel includes a plurality of systems independent of each other.

3. The stator according to claim 1 or 2,
wherein the coil inner water channels include slot inner water channels disposed in the respective slots.

4. The stator according to claim 1 or 2,
wherein the coil inner water channels include tooth inner water channels disposed in the respective tooth portions.

5. The stator according to claim 1 or 2,
wherein the coil inner water channels include yoke inner water channels disposed in the yoke portion.

6. The stator according to claim 1 or 2,
wherein each of the coil inner water channels is configured to include a path, which returns the cooling water from the one end to the other end or from the other end to the one end, unit by unit with a plurality of paths as one unit.

7. The stator according to claim 1 or 2,
wherein the header water channel includes a header water channel introduction portion that introduces the cooling water from an outside, and a header water channel discharge portion that discharges the cooling water to the outside.

8. The stator according to claim 7,
wherein the header water channel introduction portion and the header water channel discharge portion are provided on different sides in the axial direction.

9. The stator according to claim 7,
wherein the header water channel introduction portion and the header water channel discharge portion are provided on the same side in the axial direction.

10. The stator according to claim 7,
wherein the number of the header water channel introduction portions and the number of the header water channel discharge portions are the same.

11. The stator according to claim 7,
wherein the number of the header water channel introduction portions and the number of the header water channel discharge portions are different from each other.

12. The stator according to claim 1 or 2,
wherein the coil inner water channels and the header water channel are configured to include a resin layer into which a resin composition is cured, and
the resin composition is made of one or two thermosetting resins selected from the group of an epoxy resin and a phenol resin.

13. The stator according to claim 1 or 2,
wherein the header water channel adjusts water pressures at portions of the coil inner water channels to be uniform, the portions being connected to the header water channel.

14. A stator comprising:
a yoke portion;
tooth portions extending from the yoke portion;
slots formed between the tooth portions;
a coil accommodated in the slots; and
a cooling water channel that cools the coil,
wherein the cooling water channel is disposed between one end and the other end of the yoke portion in an axial direction, and is configured to include a path, which returns cooling water from the one end to the other end or from the other end to the one end, unit by unit with a plurality of paths as one unit.

15. The stator according to claim 14,
wherein the number of paths is different between external cooling water introduction paths that introduce the cooling water and external cooling water discharge paths connected to discharge the cooling water.

16. A structure comprising:
the cooling water channel included in the stator according to claim 1 or 2; and
a power module cooling water channel that is connected to the cooling water channel, and that cools a power module included in an inverter provided integrally with a motor including the stator.

17. The structure according to claim 16,
wherein the power module cooling water channel cools a semiconductor element circuit included in the power module.

18. The structure according to claim 16,
wherein the power module cooling water channel cools a capacitor included in the inverter.
